Europäisches Patentamt

European Patent Office

Office européen des brevets

(19)

(11)     EP 1 587 135 A1

(12)     EUROPEAN PATENT APPLICATION

(43) Date of publication:
    **19.10.2005   Bulletin 2005/42**

(51) Int Cl.⁷: **H01L 21/02**, H01L 23/522

(21) Application number: **04008729.8**

(22) Date of filing: **13.04.2004**

(84) Designated Contracting States:
    **AT BE BG CH CY CZ DE DK EE ES FI FR GB GR
    HU IE IT LI LU MC NL PL PT RO SE SI SK TR**
    Designated Extension States:
    **AL HR LT LV MK**

(71) Applicant: **TDK Corporation
    Tokyo (JP)**

(72) Inventor: **Humphrey, Denver Edward Johnston
    County Antrim Northen Ireland BT43 7HD (GB)**

(74) Representative: **Wallace, Alan Hutchinson et al
    F. R. Kelly & Co.
    4 Mount Charles
    Belfast BT7 1NZ, Northern Ireland (GB)**

(54)     **Helical inductor**

(57)     A generally helical inductor comprising a first conductive element (112A) being associated with an input port; a last conductive element (112D) being associated with an output port; and preferably at least one intermediate conductive element (112B,112C) being disposed between the first and the last conductive elements. The width of the first conductive element is less than the respective widths of the intermediate and last conductive elements and is preferably minimised for the fabrication technology. This allows the input shunt capacitance to be minimised thereby improving the Q-Factor of the inductor.

Fig. 2

Printed by Jouve, 75001 PARIS (FR)

## Description

## Field of the Invention

The present invention relates to inductors and in particular to inductors formed in a multi-layer substrate.

## Background to the Invention

Passive components such as inductors or capacitors play an important role in many electronic devices, including wireless communications devices such as mobile (cellular) handsets.

The Quality Factor, or Q-Factor, of a component may be used as a measure of how much loss an individual component exhibits during use. Relatively high Q-Factors indicate relatively low loss components. It is common in transmission systems, e.g. wireless communications systems, to use components with a Q-Factor that is as high as possible. This is because lossy components tend to reduce the available power for transmission or reception, meaning that more amplification is required in the system. This reduces the overall efficiency of the system and thus the battery life.

The current trend towards miniaturisation of electronic devices, and in particular mobile communications handsets, has led to electronic circuits being implemented in multi-layer structures or substrates in which circuit components are incorporated into a structure comprised of two or more layers of dielectric material. For example, a multi-layer ceramic substrate may be used to create what is commonly referred to as a Low Temperature Co-fired Ceramic (LTCC) circuit or a Multilayer Ceramic Integrated Circuit (MCIC). Typically, in such structures, many individual components are embedded in the substrate together to form a combined circuit. As a result, the Q-Factor of the individual components tends to decrease as a trade-off against increased integration and reduced circuit size. The loss in capacitor components is normally very low, even when integrated, and so most unwanted loss tends to come from the inductive components.

It would be desirable therefore to provide an inductor which is suitable for integration into multi-layer substrates and which exhibits an improved Q-Factor in comparison with conventional inductors. It would also be desirable to improve the self-resonant frequency of an inductor, where the self-resonant frequency of an inductor is the lowest frequency at which an inductor resonates with its self-capacitance. The self-capacitance is the capacitance between the individual turns of the inductor.

## Summary of the Invention

Accordingly, a first aspect of the invention provides an inductor comprising an input port for receiving electrical signals; an output port for the egress of received electrical signals; a first conductive element being associated with the input port; and a last conductive element being associated with the output port, the conductive elements being electrically interconnected and being shaped and arranged to form a generally helical structure, wherein the inductor exhibits, during use, a target inductance corresponding with an effective cross-sectional area, taken in a plane that is substantially perpendicular to the longitudinal axis of the helical structure, for the conductive elements, and wherein the respective actual cross-sectional area of at least the first conductive element is less than the effective cross-sectional area, and the respective actual cross-sectional area of at least the last conductive element is greater than the effective cross-sectional area, and wherein the respective actual cross-sectional areas cause the respective conductive elements collectively to have a substantially counter-balancing effect on the inductance exhibited by the inductor with respect to the target inductance.

Preferably, each conductive element comprises a generally planar strip of substantially uniform width, the target inductance corresponding with an effective width for the conductive elements, and wherein the respective actual widths of at least the first conductive element is less than the effective width, and the respective actual width of at least the last conductive element is greater than the effective width, and wherein the respective actual widths cause the respective conductive elements collectively to have a substantially counter-balancing effect on the inductance exhibited by the inductor with respect to the target inductance.

In preferred embodiments, the inductor further includes at least one intermediate conductive element being disposed between the first and the last conductive elements, wherein the cross-sectional area of the first conductive element, taken in a plane that is substantially perpendicular to the longitudinal axis of the helical structure, is less than the corresponding respective cross-sectional areas of the intermediate and last conductive elements. Preferably, each conductive element comprises a generally planar strip of substantially uniform width, and wherein the width of the first conductive element is less than the respective widths of the intermediate and last conductive elements.

In preferred embodiments, the area, or width, of the last conductive element is wider than the respective area or width of the or each intermediate conductive element. The respective area, or width, of the conductive elements may increase from the first conductive element to the last conductive element.

Typically, the width, or area, of the last conductive element is approximately between 2 to 3 times the width, or area, of the first conductive element.

In preferred embodiments, the inductor is incorporated into a multi-layer structure comprising a stack of dielectric layers, each layer comprising a respective conductive element such that the longitudinal axis of the generally helical structure is substantially perpendicularly disposed with respect to the layers, and wherein one or more ground elements are spaced-apart from the inductor in a direction generally parallel with the longitudinal axis and are generally parallely disposed with respect to the dielectric layers.

The conductive elements may comprise transmission lines for transporting electromagnetic transmission signals.

A second aspect of the invention provides a multi-layer structure comprising the inductor of the first aspect of the invention.

A third aspect of the invention provides a method of designing an inductor comprising an input port for receiving electrical signals; an output port for the egress of received electrical signals; a first conductive element being associated with the input port; and a last conductive element being associated with the output port, wherein the conductive elements are electrically interconnected and are shaped and arranged to form a generally helical structure, the method comprising selecting a target inductance, the target inductance corresponding with an effective width or cross-sectional area, taken in a plane that is substantially perpendicular to the longitudinal axis of the helical structure, for the conductive elements; selecting the width or cross-sectional area of at least the first conductive element to be less than the effective width or cross-sectional area; and selecting the width or cross-sectional area of at least the last conductive element to be greater than the effective width or cross-sectional area, wherein the respective widths or cross-sectional areas are selected to cause the respective conductive elements collectively to have a substantially counter-balancing effect on the inductance exhibited by the inductor with respect to the target inductance.

In preferred embodiments, the inductor further includes at least one intermediate conductive element being disposed between the first and the last conductive elements, the method further comprising selecting a value for the cross-sectional area of the first conductive element that is less than the corresponding respective cross-sectional areas of the intermediate and last conductive elements.

Preferably, each conductive element comprises a generally planar strip of substantially uniform width, and the method comprises selecting a value for the width of the first conductive element that is less than the respective widths of the intermediate and last conductive elements. Selecting a value for the cross-sectional area or width of the first conductive element preferably involves minimising the area or width.

A fourth aspect of the invention provides an inductor structure comprising a first conductive element being associated with a first port; a last conductive element being associated with a second port, wherein the conductive elements are electrically interconnected and are shaped and arranged to form a generally helical structure; and one or more ground elements located beyond the first conductive element with respect to the last conductive element and/or located beyond the last conductive element with respect to the first conductive element and being generally parallely disposed with respect to the conductive elements, wherein the ratio of the cross-sectional area of the first conductive element, taken in a plane that is substantially perpendicular to the longitudinal axis of the helical structure, to the corresponding cross-sectional area of the last conductive element is generally equal to the ratio of the distance the first conductive element from the, or each, ground plane to the distance of the last conductive element from the, or each, ground plane.

A fifth aspect of the invention provides a method of designing the inductor of the fourth aspect of the invention.

A sixth aspect of the invention provides a generally helical inductor comprising a first conductive element being associated with an input port; a last conductive element being associated with an output port; and preferably at least one intermediate conductive element being disposed between the first and the last conductive elements. The width of the first conductive element is less than the respective widths of the intermediate and last conductive elements and is preferably minimised for the fabrication technology. This allows the input shunt capacitance to be minimised thereby improving the Q-Factor of the inductor.

Other advantageous aspects of the invention will become apparent to those ordinarily skilled in the art upon review of the following description of specific embodiments of the invention and with reference to the accompanying drawings.

**Brief Description of the Drawings**

Figure 1 presents a perspective view of a conventional inductor;

Figure 2 presents a perspective view of an inductor embodying one aspect of the present invention:

Figure 3 presents a perspective view of the inductor of Figure 2 incorporated in a multi-layer structure;

Figure 4 presents a schematic view of a high frequency electrical circuit model for the inductor of Figures 1, 2 and 3;

Figure 5 is a graph plotting Q-Factor against frequency for the inductors of Figure 1 and of Figures 2 and 3;

Figure 6 is a Smith Chart plotting impedance against frequency for the inductors of Figure 1 and of Figures 2 and 3;

Figure 7 is a graph showing the difference in the forward and reverse Q-Factors for the inductor of Figure 1;

Figure 8 is a Smith Chart showing the difference in the forward and reverse impedance values for the inductor of Figure 1;

Figure 9 presents a perspective view of an inductor embodying a second aspect of the present invention;

Figure 10 presents a perspective view of the inductor of Figure 9 incorporated in a multi-layer structure;

Figure 11 is a Smith Chart showing the difference in the forward and reverse impedance values for the inductors of Figures 9 and 10;

Figure 12 is a graph showing the difference in the forward and reverse Q-Factors for the inductor of Figures 9 and 10;

Figure 13 presents a side view of the inductor of Figures 2 and 3 or Figures 9 and 10 including two ground planes spaced equidistantly from the inductor; and

Figure 14 presents a side view of the inductor of Figures 2 and 3 or Figures 9 and 10 including two ground planes spaced non-equidistantly from the inductor

**Detailed Description of the Drawings**

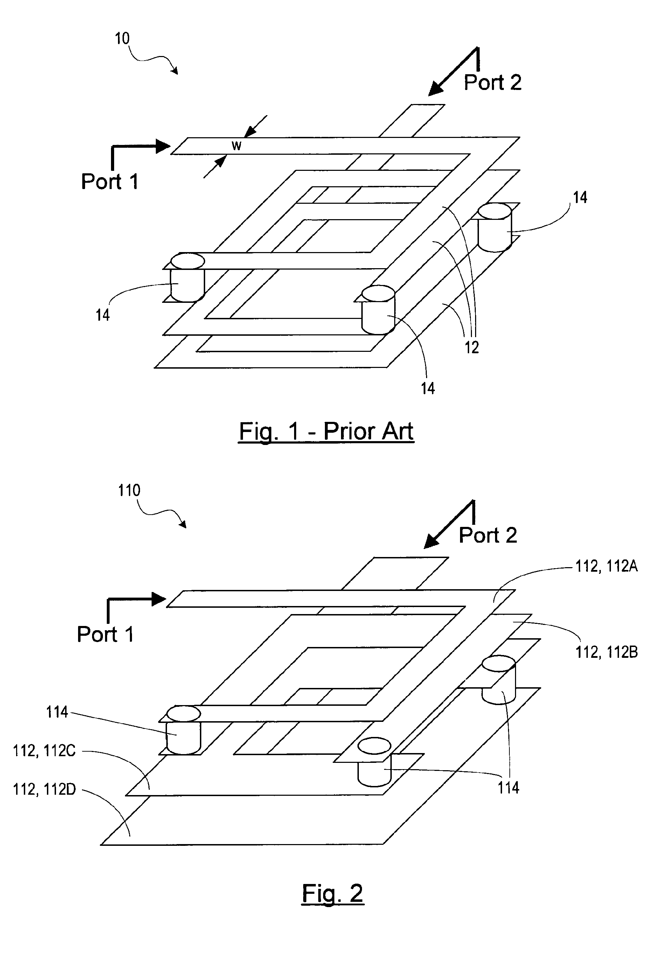

Figure 1 illustrates an example of a conventional multi-layer or helical inductor 10 comprising a plurality of electrically conductive elements 12 electrically interconnected by a plurality of electrically conductive vias 14 to form a generally helical structure. The inductor 10 comprises first and second ports *Port 1, Port 2* one of which, during use, serves as an input for electrical signals, the other serving as an output for electrical signals. Typically, each conductive element is carried by a respective substrate layer (not shown in Figure 1), the vias 14 providing an electrical path between adjacent conductive elements 12 through a respective layer of a dielectric substrate. Normally, the width W of each conductive element 12 is substantially uniform and is the same as the width W of each other conductive element 12 in the inductor 10.

Figure 2 provides a perspective view of an inductor 110 embodying one aspect of the present invention. The inductor 110 is generally similar to the inductor 10 and comprises a plurality of generally planar, electrically conductive elements 112, or strips, electrically interconnected by a plurality of electrically conductive vias 114 (or other conductive connectors) to form a generally helical structure. The inductor 110 comprises first and second ports *Port 1, Port 2* one of which, during use, serves as an input for electrical signals, the other serving as an output for electrical signals. In Figure 2, each conductive element 112 is shown by way of example as being generally U-shaped. In alternative embodiments, the conductive elements 112 may take any shape which allows them collectively to create a generally helical structure. For example, the conductive elements 112 may be generally C-shaped, L-shaped or curved (e.g. semi-circular or semi-ring). The conductive elements 112 may even be generally linear although this can be impractical when implementing the inductor in a multi-layer substrate. The conductive elements within the inductor need not necessarily be the same shape. It will be understood that the term helical as used herein does not imply strict conformance with a mathematically defined helix, but rather embraces any three dimensional multi-turn coil structure.

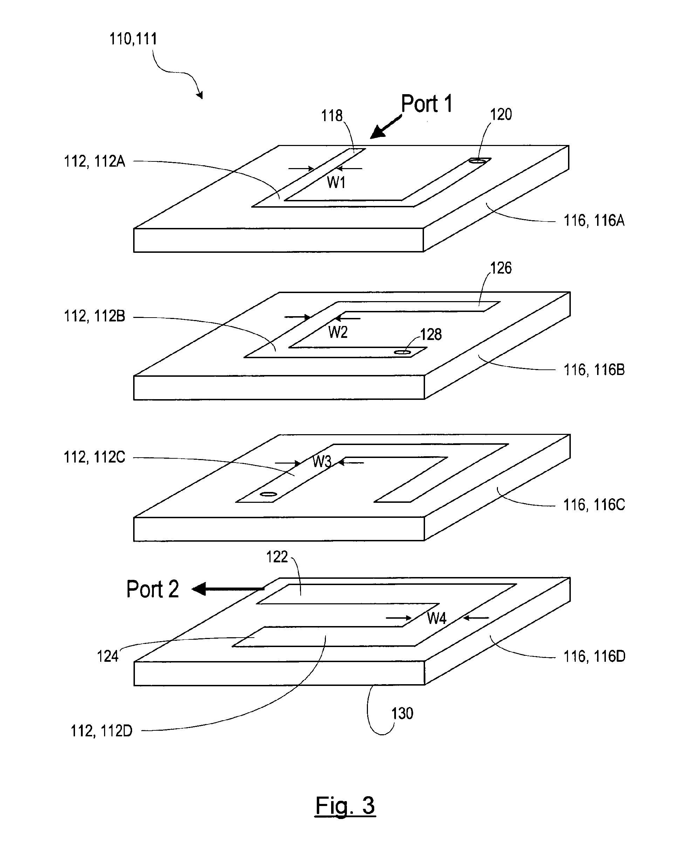

In preferred embodiments, the inductor 110 is incorporated into a multi-layer structure 111 which is illustrated in exploded view in Figure 3. Each layer of the structure 111 comprises a respective conductive element 112 carried by a respective layer 116 of dielectric substrate, for example ceramic substrate. The conductive elements 112 which are typically formed from a suitable metal, or metal composition e.g. metal paste, may be incorporated into or onto the substrate layers 116 in any conventional manner. For example, the dielectric layers 116 may be formed from ceramic materials that can be co-fired with a co-fireable metal composition using conventional LTCC technology. Typically, the conductive elements 112 comprise conductive strips or tracks and, conveniently, each track or strip is substantially uniform in width. The conductive elements 112 are usually formed in or on, and are generally co-planar with, an obverse face of the respective layer 116.

Figure 3 shows the multi-layer structure 111 in exploded view. During use, however, the layers 116 are combined to form a stack, each layer 116 in the stack being contiguous with, and generally parallel with, one or more adjacent layers 116. The multi-layer structure 111 may be said to comprise a first, or top, layer 116A, a last, or bottom, layer 116D and one or more intermediate layers 116B, 116C disposed between the first and last layers 116A, 116D. Figures 2 and 3 show an embodiment in which there are two intermediate layers 116B, 116C although in alternative embodiments there may be more intermediate layers or there may be only one intermediate layer. Alternatively still, there may be no intermediate layers and the inductor may comprise only two layers, wherein the conductive track associated with the input port is narrower than the conductive track associated with the output port.

The top layer 116A includes a conductive element 112A having a free end 118 which serves as *Port 1*, the other end 120 of the element 112A being connected to the conductive element 112B of the adjacent intermediate layer 116B by means of a via (not shown in Figure 3) which passes through the substrate layer 116A . Similarly, the bottom layer 116D includes a conductive element 112D having a free end 122 which serves as *Port 2,* the other end 124 of the element 112D being connected to the conductive element 112C of the adjacent intermediate layer 116C by means of a via. The respective conductive element 112B, 112C of the, or each, intermediate layer 116B, 116C has one end 126 connected to the conductive element 112 of one of its adjacent layers 116, the other end 128 being connected to the conductive element of its other adjacent layer 116. The arrangement is such that the conductive elements 112 when interconnected together form a generally helical structure, or multi-turn coil. To this end, in preferred embodiments the orientation of the conductive element 112 in successive layers 116 is displaced with respect to the conductive element 112 of the preceding adjacent layer 116 by approximately 90° in the same directional sense, the displacement being about a common longitudinal axis which is substantially perpendicular to the layers 16. The conductive elements 112 together provide an electrical signal path through the substrate layers 116 between *Port 1* and *Port 2.*

One or more ground elements, typically in the form of a ground plane (not shown) for providing a reference potential is also provided. In preferred embodiments, a ground plane is substantially parallelly disposed with respect to the layers 116 and may be provided beyond the bottom layer 116D with respect to the structure 111 (e.g. on the reverse face 130 of the bottom layer 116D) or may be provided beyond the top layer 116A with respect to the structure 111. Alternatively, two ground planes may be provided, one substantially parallel with and beyond the top layer 116A, the other being substantially parallel with and beyond the bottom layer 116D.

The multi-layer structure 111 may be said to comprise a multi-layer inductor 110. The multi-layer inductor 110 is particularly suitable for use in electronic circuits implemented in multi-layer substrates, for example MCICs. Such circuits are commonly used in mobile telecommunications handsets and other telecommunications devices and, in such applications, the multi-layer inductor 110 may be required to receive electromagnetic transmission signals such as RF (radio frequency) or microwave signals. Hence, the conductive elements 112 may comprise transmission lines suitable for transporting such signals. The structure 111 may therefore be used in any RF multi-layer dielectric circuit where a helical inductor is required and more specifically in applications where the inductor can cause a loss in the RF signal circuit path, e.g. in a diplexer. The structure 111 is also particularly useful for use in power amplifier dielectric modules as used in, for example mobile telephones, where loss in matching components reduces the available output power and thus reduces the module efficiency. In addition, the inductor 110/structure 111 can be used for applications at higher frequencies since the self resonant frequency of the inductor is improved in comparison with conventional inductors. The inductor 110 is also particularly suited for use in Front End Module multi-layer structures and for Power Amplifier multi-layer matching modules.

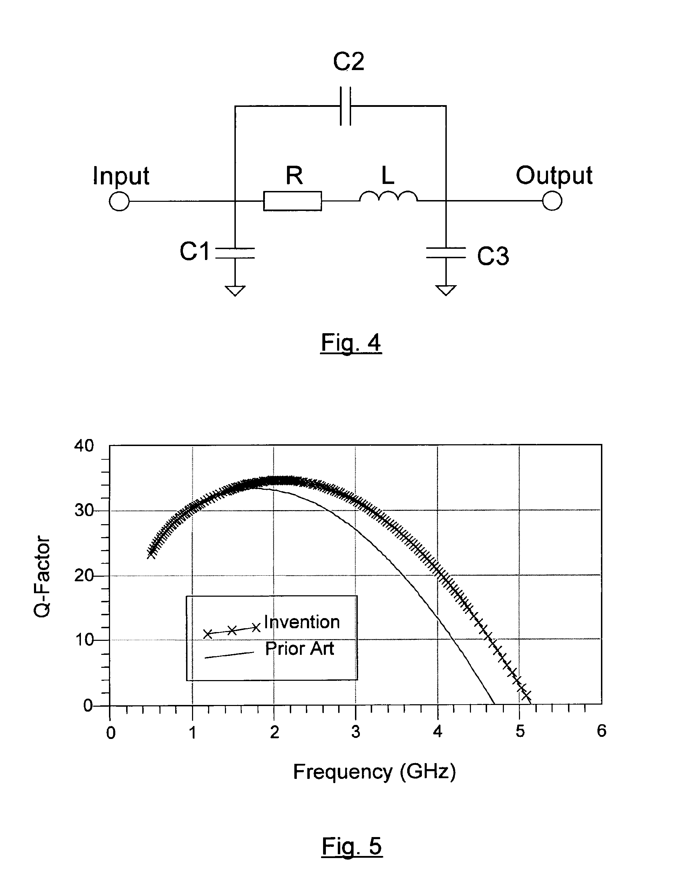

Figure 4 presents a schematic circuit model of the multi-layer structure 111 or inductor 10, 110. The circuit model comprises an input and an output which correspond with a respective one of *Port 1* and *Port* 2 depending on how the inductor 110 is incorporated into an electric circuit during use. For the purposes of illustration, it is assumed that *Port 1* serves as the input and that *Port 2* serves as the output, i.e. the inductor 110 is connected to, or incorporated within, an electrical circuit so that electrical signals are input to the inductor 110 at *Port 1* and are output from the inductor 110 at *Port 2* . Capacitance C 1 is generally representative of a shunt capacitance between the input and ground which in the present example is determined by the electrical interaction between the conductive element 112A (i.e. the conductive element associated with or providing the input port) and the ground plane(s). Capacitance C3 is generally representative of a shunt capacitance between the output and ground which in the present example is determined by the electrical interaction between the conductive element 112D (i.e. the conductive element associated with or providing the output port) and the ground plane(s). Capacitance C2 represents the capacitive coupling between the turns of the inductor 110 which in the present example is determined by the electrical coupling between the conductive elements 112. Resistance R and inductance L represent, respectively, the electrical resistance and electrical inductance between the input and output and are determined by the number and nature of the conductive elements 112.

From the circuit model of Figure 4, an equation for determining the Q-Factor, Q, of the inductor 110 can be derived:

$$Q = \frac{\omega}{R}[L\cdot(1-\omega^2 LC_2-\omega^2 LC_1) - R^2(C_1+C_2)] \qquad [1]$$

where $\omega$ is the radian frequency of the electrical signal received by the inductor 110 during use.

From equation [1], it may be seen that the input shunt capacitance C1, the resistance R and the coupling capacitance C2 each have a detrimental effect on the Q-Factor. Accordingly, the Q-factor may be improved by decreasing or minimising the value of C1. In this connection, it is observed that the value of C1 is generally directly proportional to the area of the conductive track 112A and generally inversely proportional to the distance between the conductive track 112A and ground. In many applications where space is at a premium, it is considered to be undesirable or impractical to adjust the distance between the conductive track 112A and ground. It is decided therefore to reduce or minimise the value of capacitance C 1 by decreasing or minimising the area of the conductive track 112A associated with the input In the preferred embodiment, the conductive tracks 112 are of substantially equal length (although the first and last tracks 112A, 112D may be longer in order to provide the ports). Each conductive track 112 is substantially uniform in width along its length and so the area of the conductive track 112A may be decreased or minimised by decreasing or minimising the width W1 of the conductive track 112A. It is preferred to make the width W1 of conductive track 112A as narrow as is permitted by the fabrication technology with which the structure 111 is implemented. This may depend, for example, on the fineness of the printing screen mesh (not shown) and/or on the viscosity of the metal composition used to create the tracks 112.

By way of example, the width W 1 may be in the region of 60microns.

However, narrowing the width W 1 of conductive track 112A also has the effect of increasing the inductance L. Inductance L is generally proportional to the length of the tracks 112 and generally inversely proportional to the area of the tracks 112. To counteract the increase in inductance L, the area of the conductive tracks 112 of one or more of the other layers 116 in the stack 111 is adjusted or increased (conveniently by widening the or each track 112) relative to the width or area of the first track 112A and relative to the track width or area that would normally be required to provide a conventional inductor 10 of inductance L. In the preferred embodiment, the width W4 (and therefore the area) of the bottom conductive track 112D, i.e. the conductive track associated with the output, is increased by an amount sufficient to at least partially counteract the increase in inductance L caused by the narrowing of the conductive track 112A. This allows the inductor 110 to be designed to a target inductance value L. By way of example, the width W4 of track 112D may be approximately 140 - 150 microns. For typical applications, it is found that the width W4 of the last track 112D is in the region of 2 to 3 times as wide as the first track 112A although this depends on the individual length of the tracks 112.

Increasing the width W4 of the conductive track 112D has the effect of increasing capacitance C3 but, as may be seen from equation [1], the value of C3 has no appreciable effect on the Q-Factor. Moreover, since track width W is inversely proportional to the resistance R, it is found that the narrowing of the conductive track 112A and the corresponding widening of conductive track 112D have a counteracting effect on the resistance R with the result that the net change in the value of R is minimal and so improvements in the Q-Factor are not appreciably negated. In addition, since the inter-turn capacitance C2 is also proportional to track width, the net effect on the value of C2 is also minimal. The width (or area) of one or more of the intermediate tracks 112B, 112C may additionally, or alternatively, be increased in order to compensate for the narrowing of the first track 112A. However, it is preferred to use the bottom track 112D for this purpose since the width or area of the bottom track 112D has a relatively low effect on the value of C2.

For typical applications, the inductor 110 is required to exhibit a target inductance L. The preferred design method involves determining an effective width for each conductive track 112 based on the target inductance and assuming a conventional inductor structure in which all conductive tracks are of the same width. Hence, the effective width may be said to be a notional common width for the tracks 112. An actual value for the width W 1 of the first track 112A is selected which is less than the effective width and is preferably as narrow as is allowed by the fabrication technology. This in itself would have the effect of increasing the inductance with respect to the target inductance. An actual value for the width W4 of the last track 112D is then determined which is greater than the effective width and which has the effect of adjusting the inductance of the inductor 110 so as to at least partially counteract the increase in inductance (compared to the target inductance) which would otherwise be caused by the selected width W1 of the first track 112A. In some embodiments, the respective selected widths W1, W4 of the first and last track 112A, 112D have a substantially counter-balancing effect on the inductance with respect to the target inductance such that the inductor 110 exhibits the target inductance. In such embodiments, the respective widths W2, W3 of the or each intermediate track 112B, 112C may be selected to be substantially equal to the effective width. In other embodiments, it may not be possible or practical to select a width W4 for the last track 112D which counterbalances the effect of the width W 1 of the first track 112A. In such cases, the respective widths W2, W3 of one or more of the intermediate tracks 112B, 112C may be adjusted so that the target inductance is achieved. In cases where there are two or more intermediate tracks, it is preferred to adjust intermediate track widths so that the respective track widths increase from the first track to the last track. For example, the width of the track 112B adjacent the first track 112A may be decreased (with respect to the effective track width) and/or the width of the track 112C adjacent the first track 112D may be increased (with respect to the effective track width). This approach allows the inductance to be adjusted while minimising any detrimental effect on the Q-Factor. The design method described above is not limited to the four layer embodiment shown in Figures 2 and 3 and applies not only to track widths but also to track areas.

In the preferred embodiment, the inductor 110 comprises two (or more) intermediate layers 116B, 116C and the respective widths W1-W4 (and therefore the areas) of the conductive tracks 112A - 112D of each layer 116A-116D increase progressively (although not necessarily in uniform increments) from the first layer 116A (i.

e. the layer associated with the signal input) to the last layer 116D (i.e. the layer associated with the signal output). Alternatively, the respective widths of the intermediate tracks 112B, 112C may be substantially the same, but greater than the width of the first track 112A and less than the width of the last track 112D.

In an alternative embodiment (not illustrated), the inductor comprises only one intermediate layer and the respective widths of the conductive tracks of each layer increase progressively (although not necessarily in uniform increments) from the first layer (i.e. the layer associated with the signal input) to the last layer (i.e. the layer associated with the signal output) .

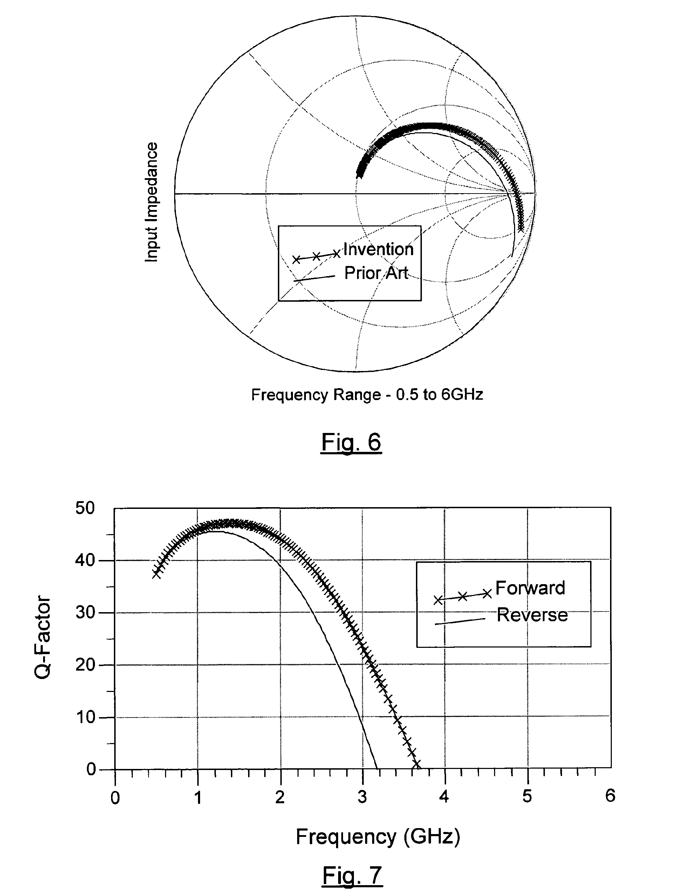

In each embodiment, the respective widths W of the conductive tracks are selected to provide a low or minimum shunt capacitance between the input port and ground while still providing a desired inductance value L. Thus, the inductor 110 may be designed to be more ideal with respect to the input port (*Port 1* in the present example), thereby improving the overall performance of the circuit (not shown) into which the inductor 110 is incorporated during use. By way of example, Figure 5 shows the respective Q-Factors of the inductors 10, 110 plotted against frequency. It is observed that the inductor 110 exhibits an improved Q-Factor (by approximately 10% at 2.5GHz (Bluetooth)) and an increased self resonant frequency of approximately 10% in comparison with the inductor 10. In addition, from Figure 6, which shows a Smith Chart plotting impedance against frequency, it is observed that the value of the resulting inductance L of inductor 110 is decreased by only 1.3% in comparison with the inductor 10.

For the results shown in Figures 5 and 6, the length of each arm of each conductive track 112 is approximately 640um and is incorporated into dielectric layers having a dielectric constant of approximately 7.5 and depth of approximately 40um. The bottom conductive layer 112D is approximately 150um from the ground plane.

Further advantages offered by the first aspect of the invention include that a multi-layer dielectric inductor with a relatively high Q-Factor can be easily integrated into dielectric structures; improved low-loss matching circuits can be made using multi-layer technology; improvements in efficiency of high power multi-layer dielectric modules; and the self resonant frequency of the inductor may be improved.

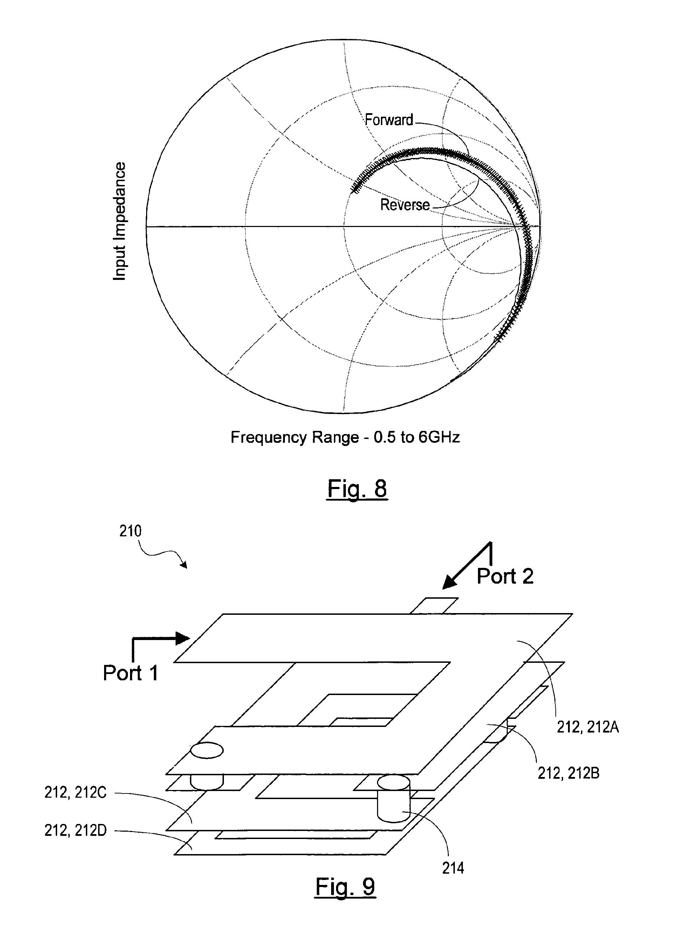

Turning now to a second aspect of the invention, from equation [1] it can be observed that the Q-Factor in the reverse direction (i.e. as seen from the output port, *Port 2*) is different than in the forward direction (i. e. as seen from the input port, *Port 1*), since, in equation [1], the roles of C1 and C3 are swapped and the respective values C 1 and C3 are not the same. The respective Q-Factor and return loss for the inductor 10 of Figure 1 in the forward and reverse directions are shown in Figures 7 and 8. It may be seen that, in the reverse direction, the Q-Factor is degraded significantly with respect to the forward direction and, at higher frequencies, the effective inductance value L is also significantly different.

For some circuit applications, an inductor may have to receive input signals in both the forward and reverse directions, i.e. Port 1 and Port 2 may be required to serve as the input and output respectively or as the output and input respectively. To this end, it would be desirable for the Q-Factor of the inductor to be substantially the same in both the forward and reverse directions. Hence, in accordance with the second aspect of the invention, the respective widths of the conductive elements or transmission lines are adjusted so that the reverse Q-Factor and inductance value L are substantially the same as for the forward direction. To this end it is desired to make the value of C1 and C3 be substantially the same.

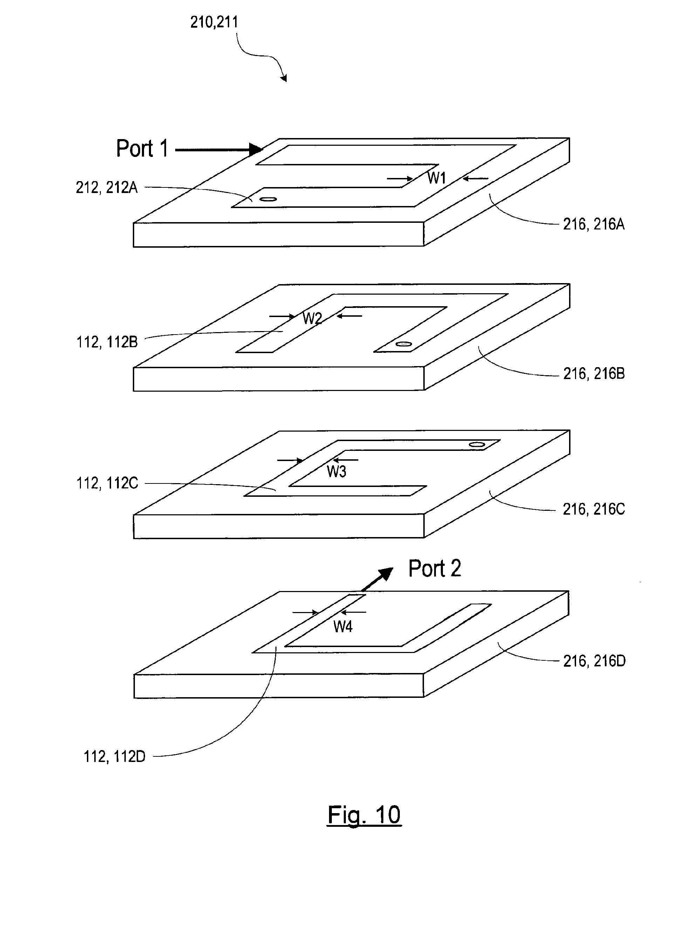

Figures 9 and 10 illustrate an inductor 210 and multi-layer structure 211 embodying this aspect of the invention. The structure 211 shown in Figures 9 and 10 is generally similar to the structure 111 shown in Figures 2 and 3 and like numerals are used to indicate like parts. It is assumed in the embodiment of Figures 9 and 10 that there is a single ground plane (not shown) provided beyond the last layer 216D with respect to the multi-layer structure 211 (i.e. below the substrate layer 216D associated with *Port 2* as viewed in the drawings). Bearing in mind that capacitance is proportional to the area of the conductive element and inversely proportional to the distance of the conductive element from the ground plane, then in cases where the ground plane is below the structure 211, the area of the conductive track 212D associated with *Port 2* must be less than that of the conductive track 212A associated with *Port 1*, since conductive track 212D is closer to the ground plane than conductive track 212A is. In preferred embodiments where the track widths W are substantially uniform within each layer 216, this is conveniently achieved by adjusting the respective widths W1, W4 of the tracks 212A, 212D. Hence, in the structure 211, the track width W1 is wider then the track width W4 by an amount which depends on the respective distances from the respective tracks 212A, 212D to the ground plane.

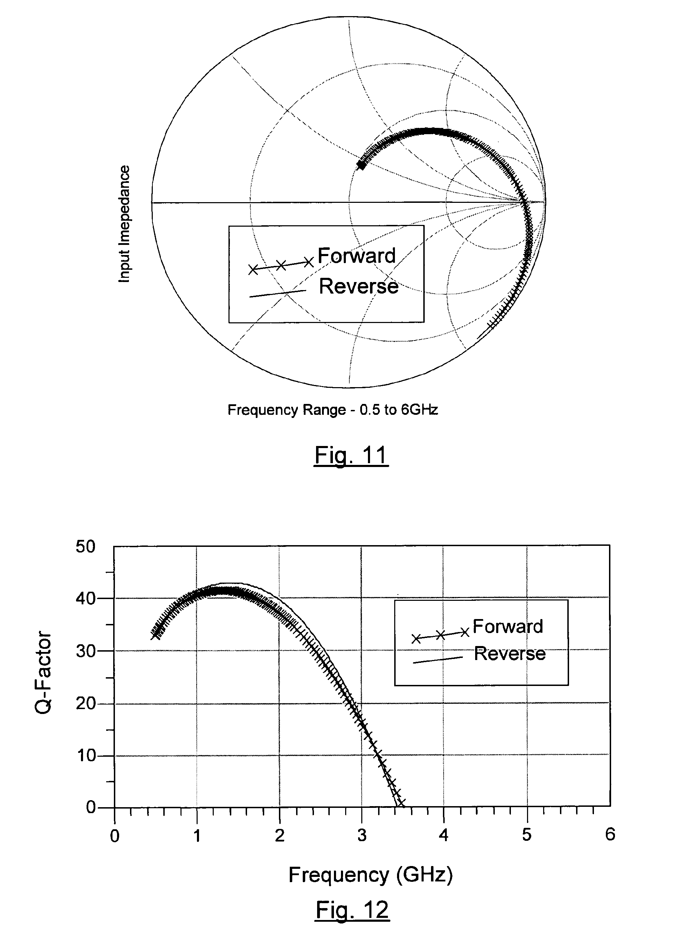

In the preferred embodiment, the respective widths W1-W4 (and therefore areas) of the conductive tracks 212A - 212D of each layer 216A-216D decrease progressively (although not necessarily in uniform increments) from the first layer 216A (i.e. the layer associated with the signal input) to the last layer 216D (i.e. the layer associated with the signal output). Alternatively, the respective widths of the intermediate tracks 212B, 212C may be substantially the same, but less than the width of the first track 212A and greater than the width of the last track 212D. From Figures 11 and 12 it may be seen that, for the inductor 210 there is substantially no difference in the respective inductance value L (7.68nH) in the forward and reverse directions and very little difference in the respective forward and reverse Q-Factors.

In cases where the ground plane (not shown) is provided above the first layer 212A, then the description for the structure 211 applies but in reverse, i.e. the area of the conductive track 212D associated with *Port 2* must be greater than that of the conductive track 212A associated with *Port 1*, since conductive track 212A is closer to the ground plane than conductive track 212D is.

As a design guideline, it can be assumed that the ratio of the area (or width) of the conductive track associated with one port to the area (or width) of the conductive track associated with the other port is generally equal to the ratio of the distance (conveniently the perpendicular distance) of the conductive track associated with said one port from the ground plane to the distance (conveniently the perpendicular distance) of the conductive track associated with said other port from the ground plane.

In alternative embodiments, the inductor 210 may comprise no intermediate layers, only one intermediate layer, or more than two intermediate layers.

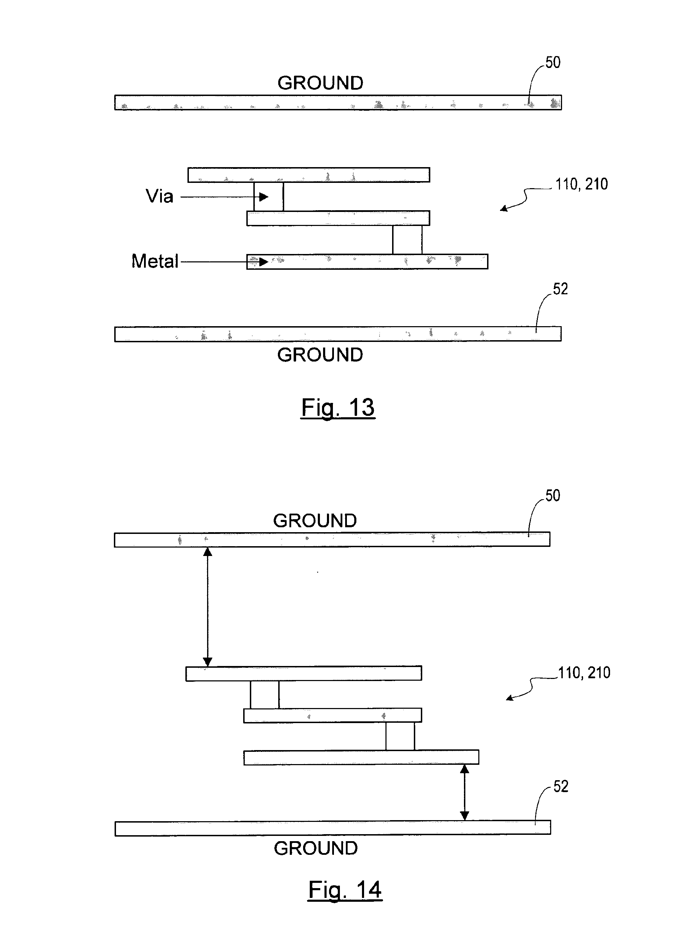

In cases where the multi-layer structure 111, 211 is provided between two reference potentials, or ground planes 50, 52, one above and one below the multi-layer structure (see Figures 13 and 14), then if the upper potential or plane 50 is substantially the same distance away from the top layer 116A, 216A as the lower plane 52 is from the bottom layer 116D, 216D (Figure 13), then the Q-Factor and inductance value in the reverse direction will substantially equal those in the forward direction if the conductive tracks of the first and last layers are the same and the conductive tracks of the intermediate layers are the same. The Q-Factor can be increased in the forward direction by narrowing the width of the conductive track 112A and increasing the respective widths of at least one of the other conductive tracks 112B-112D, as described with reference to Figures 2 and 3. If the upper and lower reference potentials are not equidistant from the structure 111, 211 (Figure 14), then the equalisation technique described with reference to Figures 9 and 10 may be also be employed in order that the inductance and Q-Factor in the forward and reverse directions may be equalised.

In alternative embodiments of both aspects of the invention, the inductor 110, 210 is not provided in a multi-layer substrate and may comprise a stand-alone structure (e.g. surrounded by air) or may have a core of magnetic material.

The invention is not limited to the embodiments described herein which may be modified or varied without departing from the scope of the invention.

**Claims**

1. An inductor comprising an input port for receiving electrical signals; an output port for the egress of received electrical signals; a first conductive element being associated with the input port; and a last conductive element being associated with the output port, the conductive elements being electrically interconnected and being shaped and arranged to form a generally helical structure, wherein the inductor exhibits, during use, a target inductance corresponding with an effective cross-sectional area, taken in a plane that is substantially perpendicular to the longitudinal axis of the helical structure, for the conductive elements, and wherein the respective actual cross-sectional area of at least the first conductive element is less than the effective cross-sectional area, and the respective actual cross-sectional area of at least the last conductive element is greater than the effective cross-sectional area, and wherein the respective actual cross-sectional areas cause the respective conductive elements collectively to have a substantially counter-balancing effect on the inductance exhibited by the inductor with respect to the target inductance.

2. An inductor as claimed in Claim 1, wherein each conductive element comprises a generally planar strip of substantially uniform width, the target inductance corresponding with an effective width for the conductive elements, and wherein the respective actual widths of at least the first conductive element is less than the effective width, and the respective actual width of at least the last conductive element is greater than the effective width, and wherein the respective actual widths cause the respective conductive elements collectively to have a substantially counter-balancing effect on the inductance exhibited by the inductor with respect to the target inductance.

3. An inductor as claimed in Claim 1 or 2, further including at least one intermediate conductive element being disposed between the first and the last conductive elements, wherein the cross-sectional area of the first conductive element, taken in a plane that is substantially perpendicular to the longitudinal axis of the helical structure, is less than the corresponding respective cross-sectional areas of the intermediate and last conductive elements.

4. An inductor as claimed in Claim 3, wherein each conductive element comprises a generally planar strip of substantially uniform width, and wherein the width of the first conductive element is less than the respective widths of the intermediate and last conductive elements.

5. An inductor as claimed in any preceding claim, in which the cross-sectional area, or width, of the last conductive element is wider than the respective cross-sectional area or width of the or each intermediate conductive element.

6. An inductor as claimed in any preceding claim, wherein the respective cross-sectional area, or width, of the conductive elements increases from the first conductive element to the last conductive element.

7. An inductor as claimed in any preceding claim, wherein the respective widths or cross-sectional areas of the first and last conductive elements cause the first and last conductive elements to have a substantially counter-balancing effect on the inductance exhibited by the inductor with respect to the target inductance.

8. An inductor as claimed in any preceding claim, wherein the width, or cross-sectional area, of the last conductive element is approximately between 2 to 3 times the width, or cross-sectional area, of the first conductive element.

9. An inductor as claimed in any preceding claim, wherein the inductor is incorporated into a multi-layer structure comprising a stack of dielectric layers, each layer comprising a respective conductive element such that the longitudinal axis of the generally helical structure is substantially perpendicularly disposed with respect to the layers, and wherein one or more ground elements are spaced-apart from the inductor in a direction generally parallel with the longitudinal axis and are generally parallely disposed with respect to the dielectric layers.

10. An inductor as claimed in any preceding claim, wherein the conductive elements comprise transmission lines for transporting electromagnetic transmission signals.

11. An inductor comprising an input port for receiving electrical signals; an output port for the egress of received electrical signals; a first conductive element being associated with the input port; a last conductive element being associated with the output port; and at least one intermediate conductive element being disposed between the first and the last conductive elements, wherein the conductive elements are electrically interconnected and are shaped and arranged to form a generally helical structure, and wherein the cross-sectional area of the first conductive element, taken in a plane that is substantially perpendicular to the longitudinal axis of the helical structure, is less than the corresponding respective cross-sectional areas of the intermediate and last conductive elements.

12. A method of designing an inductor comprising an input port for receiving electrical signals; an output port for the egress of received electrical signals; a first conductive element being associated with the input port; and a last conductive element being associated with the output port, wherein the conductive elements are electrically interconnected and are shaped and arranged to form a generally helical structure, the method comprising selecting a target inductance, the target inductance corresponding with an effective width or cross-sectional area, taken in a plane that is substantially perpendicular to the longitudinal axis of the helical structure, for the conductive elements; selecting the width or cross-sectional area of at least the first conductive element to be less than the effective width or cross-sectional area; and selecting the width or cross-sectional area of at least the last conductive element to be greater than the effective width or cross-sectional area, wherein the respective widths or cross-sectional areas are selected to cause the respective conductive elements collectively to have a substantially counter-balancing effect on the inductance exhibited by the inductor with respect to the target inductance.

13. A method as claimed in Claim 12, wherein the inductor further includes at least one intermediate conductive element being disposed between the first and the last conductive elements, the method further comprising selecting a value for the cross-sectional area of the first conductive element that is less than the corresponding respective cross-sectional areas of the intermediate and last conductive elements.

14. A method as claimed in Claim 12 or 13, wherein each conductive element comprises a generally planar strip of substantially uniform width, and wherein the method comprises selecting a value for the width of the first conductive element that is less than the respective widths of the intermediate and last conductive elements.

15. A method as claimed in any one of Claims 12 to 14, wherein selecting a value for the cross-sectional area or width of the first conductive element involves minimising the area or width.

16. An inductor structure comprising a first conductive element being associated with a first port; a last conductive element being associated with a second port, wherein the conductive elements are electrically interconnected and are shaped and arranged to form a generally helical structure; and one or more ground elements located beyond the first conductive element with respect to the last conductive element and/or located beyond the last conductive element with respect to the first conductive element and being generally parallely disposed with respect to the conductive elements, wherein the ratio of the cross-sectional area of the first conductive element, taken in a plane that is substantially perpendicular to the longitudinal axis of the helical structure, to the corresponding cross-sectional area of the last conductive element is generally equal to the ratio of the distance the first conductive element from the, or each, ground plane to the distance of the last conductive element from the, or each, ground plane.

10

Port 2

Port 1

W

14

14

14

12

Fig. 1 - Prior Art

110

Port 2

Port 1

114

112, 112A

112, 112B

112, 112C

112, 112D

114

Fig. 2

110,111

118    Port 1    120

112, 112A    W1    116, 116A

126

112, 112B    W2    128    116, 116B

112, 112C    W3    116, 116C

122

Port 2    W4

124    116, 116D

112, 112D    130

Fig. 3

C2

Input          R          L          Output

C1                                    C3

Fig. 4

Q-Factor

40

30

20

10

0

0    1    2    3    4    5    6
Frequency (GHz)

×—×—× Invention
——— Prior Art

Fig. 5

Frequency Range - 0.5 to 6GHz

## Fig. 6

## Fig. 7

Input Impedance

Forward

Reverse

Frequency Range - 0.5 to 6GHz

## Fig. 8

210

Port 2

Port 1

212, 212A

212, 212B

212, 212C

212, 212D

214

## Fig. 9

210,211

Port 1

212, 212A

W1

216, 216A

112, 112B

W2

216, 216B

112, 112C

W3

216, 216C

Port 2

W4

216, 216D

112, 112D

Fig. 10

Input Imepedance

Forward
Reverse

Frequency Range - 0.5 to 6GHz

Fig. 11

50
40
30
Q-Factor
20
10
0

0    1    2    3    4    5    6
Frequency (GHz)

Forward
Reverse

Fig. 12

GROUND

50

Via

Metal

110, 210

52

GROUND

Fig. 13

GROUND

50

110, 210

52

GROUND

Fig. 14

**European Patent Office**

## EUROPEAN SEARCH REPORT

Application Number

EP 04 00 8729

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 143 517 A (CHARTERED SEMICONDUCTOR MFG IN) 10 October 2001 (2001-10-10) * paragraphs '0079! - '0081!; figures 8a-8c * | 1-15 | H01L21/02 H01L23/522 |
| X | US 5 831 331 A (LEE SHENG-HANN) 3 November 1998 (1998-11-03) * column 4, line 35 - column 7, line 67; figures 3-6 * | 1-15 | |
| A | US 2003/214378 A1 (TUNG JOHN C ET AL) 20 November 2003 (2003-11-20) * paragraphs '0032!, '0038!; figures 4a,6a * | 16 | |
| A | WO 98/50956 A (THE BOARD OF TRUSTEES OF THE LELAND STANFORD JUNIOR UNIVERSITY) 12 November 1998 (1998-11-12) * page 8; figures 4a,4b * * page 14, lines 1-18; figure 7 * | 16 | |

TECHNICAL FIELDS SEARCHED (Int.Cl.7)

H01L
H01F

The present search report has been drawn up for all claims

| Place of search | Date of completion of the search | Examiner |
|---|---|---|
| Munich | 16 March 2005 | Blackley, W |

European Patent
Office

Application Number

EP 04 00 8729

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**European Patent Office**

**LACK OF UNITY OF INVENTION
SHEET B**

Application Number

EP 04 00 8729

The Search Division considers that the present European patent application does not comply with the requirements of unity of invention and relates to several inventions or groups of inventions, namely:

1. claims: 1-15

   Inductor having conducting layers of varying widths
   ---

2. claim: 16

   Inductor having firsst and last conductive elements wherein the ratio of widths of the conductive elements is generally equal to the ratio of respective distances from the conductive elements to associated ground planes
   ---

**ANNEX TO THE EUROPEAN SEARCH REPORT
ON EUROPEAN PATENT APPLICATION NO.**

EP 04 00 8729

This annex lists the patent family members relating to the patent documents cited in the above–mentioned European search report.
The members are as contained in the European Patent Office EDP file on
The European Patent Office is in no way liable for these particulars which are merely given for the purpose of information.

16-03-2005

| Patent document cited in search report | | | Publication date | Patent family member(s) | | Publication date |
|---|---|---|---|---|---|---|
| EP 1143517 | A | | 10-10-2001 | US | 6800533 B1 | 05-10-2004 |
| | | | | EP | 1143517 A2 | 10-10-2001 |
| | | | | SG | 90742 A1 | 20-08-2002 |
| | | | | US | 2003013264 A1 | 16-01-2003 |
| US 5831331 | A | | 03-11-1998 | EP | 0888637 A1 | 07-01-1999 |
| | | | | WO | 9822981 A1 | 28-05-1998 |
| | | | | JP | 2000504497 T | 11-04-2000 |
| US 2003214378 | A1 | | 20-11-2003 | NONE | | |
| WO 9850956 | A | | 12-11-1998 | AU | 6468198 A | 27-11-1998 |
| | | | | WO | 9850956 A1 | 12-11-1998 |

EPO FORM P0459

For more details about this annex : see Official Journal of the European Patent Office, No. 12/82